(19) Europäisches Patentamt European Patent Office Office européen des brevets

(11) **EP 4 677 981 A1**

(12) **EUROPEAN PATENT APPLICATION**

(43) Date of publication:
**14.01.2026 Bulletin 2026/03**

(21) Application number: **25183787.8**

(22) Date of filing: **18.06.2025**

(51) International Patent Classification (IPC):
**A01B 69/00** (2006.01)

(52) Cooperative Patent Classification (CPC):
**A01B 69/007**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **20.06.2024 GB 202408910**

(71) Applicant: **AGCO International GmbH**
**8212 Neuhausen am Rheinfall (CH)**

(72) Inventors:
• **BECH, Søren**
**DK8900 Randers (DK)**

• **LAUSDAHL, Kenneth**
**DK8900 Randers (DK)**
• **ZHOU, Kun**
**8930 Randers (DK)**
• **NILSSON, Rene**
**DK8900 Randers (DK)**
• **LUND, Jens**
**DK8900 Randers (DK)**

(74) Representative: **AGCO Intellectual Property Department**
**AGCO Limited**
**Abbey Park Stoneleigh**
**Kenilworth CV8 2TQ (GB)**

(54) **MODEL-BASED ROUTE PLANNING AND GRAPHICAL USER INTERFACES FOR THE PLANNING**

(57) Technologies for generating field boundaries. In some embodiments, a method includes receiving, by a computing system (102, 200), mobile machine location information (104) (step 302). The information including a series of time-stamped locations of a mobile machine (110) as it moves through an area of land during a time period. The machine including an implement used for farming, construction, or forestry. The method also including receiving, by the system, satellite images of the area (106) (step 304). The method also including using, by the system, a machine learning model (109b) to generate a model-based bounding box (112, 1202a) for the area (step 308). The method can also include generating, by the system, a graphic of the box (step 702). The box graphic (1202a) can be generated within a graphical mapped area of land. And, the method can include displaying, via a GUI (116, 216, 1100), the box graphic within the graphical mapped area (step 704).

FIG. 1

**Description**

**TECHNICAL FIELD**

The present disclosure relates to methods and systems to generate routing plans for mobile machines, such as farming machines, and related graphical user interfaces (GUIs).

**BACKGROUND**

It is known to perform path planning for various operations, such as agricultural or construction operations. Such planning is often performed manually by the operator of machines working in an environment in an attempt to optimize the operation in terms of efficiency and cost. More recently, computing systems have been developed that suggest operational paths to an operator based on an operational task, field slope, etc.; however, there is much room for improvement in such systems. In some cases, route planning has relied on manual planning, expert knowledge, and simple computations (e.g., heuristic algorithms) performed by computing systems. However, such planning does not consider the complex interactions between various factors, such as terrain, ground conditions, soil type, weather conditions, and machinery capabilities. With the complex interactions not being considered, route planning can include subpar paths and increased fuel consumption, ultimately resulting in higher operational costs and reduced productivity.

Also, having an accurate field boundary is useful for modern-day farming and other types of operations that occur within larger land areas. For example, in precision farming, the field boundary usually must be known to devise a plan for a farming task. The boundary can be useful to generate waylines, for instance. However, in many countries, a database of fields does not exist, and therefore the farmers need to create these field boundaries on their own. This leads to inaccurate boundaries often; and therefore, waylines and routes are commonly less efficient than they should be. Typically, farmers use satellite images. However, creating the field boundary using only satellite image data usually leads to an uncertainty of the boundary and can harm the planning of operations.

Thus, it would be advantageous to provide a system (and associated method) that overcomes or at least mitigates one or more problems associated with the prior art methods and considers complex interactions between various factors.

**SUMMARY**

Described herein are improved methods and systems to generate routing plans for mobile machines, such as farming machines, and related graphical user interfaces (GUIs). Also, described herein are techniques for using machine learning to generate routing plans of mobile machines. The mobile machines can be or include mobile agricultural machines, mobile construction machines, mobile forestry machines, or mobile landscaping machines, for example. The techniques disclosed herein provide specific technical solutions to at least overcome the technical problems mentioned in the background section or other parts of the application as well as other technical problems not described herein but recognized by those skilled in the art.

In some embodiments, the techniques include technologies to generate routing plans for mobile machines and related GUIs. Some embodiments include a method that includes generating routing plans of mobile machines and related GUIs. With respect to some embodiments, disclosed herein are computerized methods for generating routing plans of mobile machines and generating related GUIs as well as a non-transitory computer-readable storage medium for carrying out technical operations of the computerized methods. The non-transitory computer-readable storage medium has tangibly stored thereon, or tangibly encoded thereon, computer-readable instructions that when executed by one or more devices (e.g., one or more personal computers or servers) cause at least one processor to perform a method for improved systems and methods for generating routing plans of mobile machines and generating related GUIs.

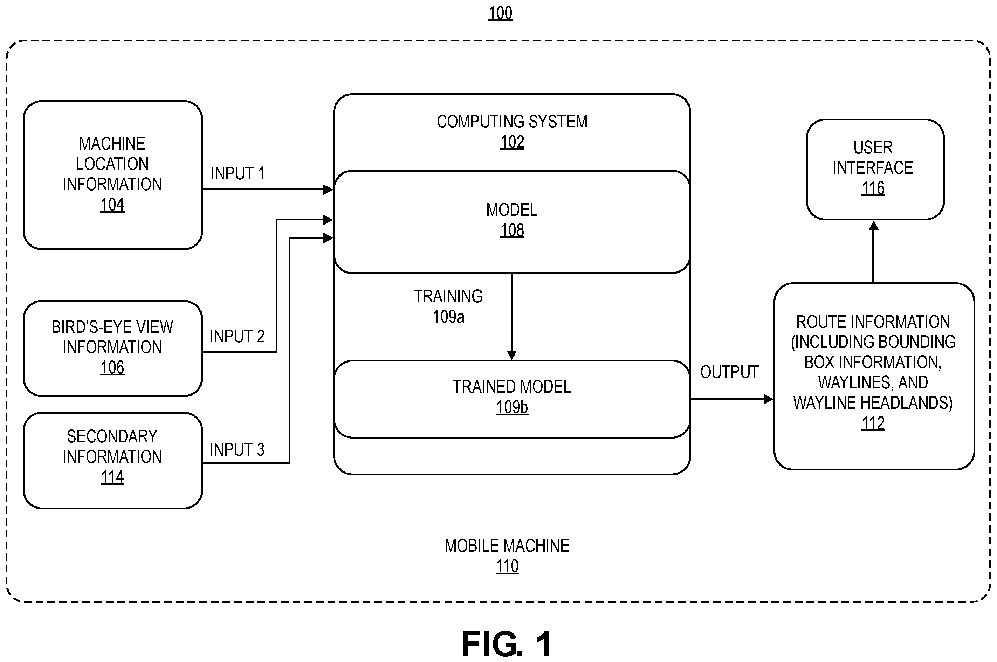

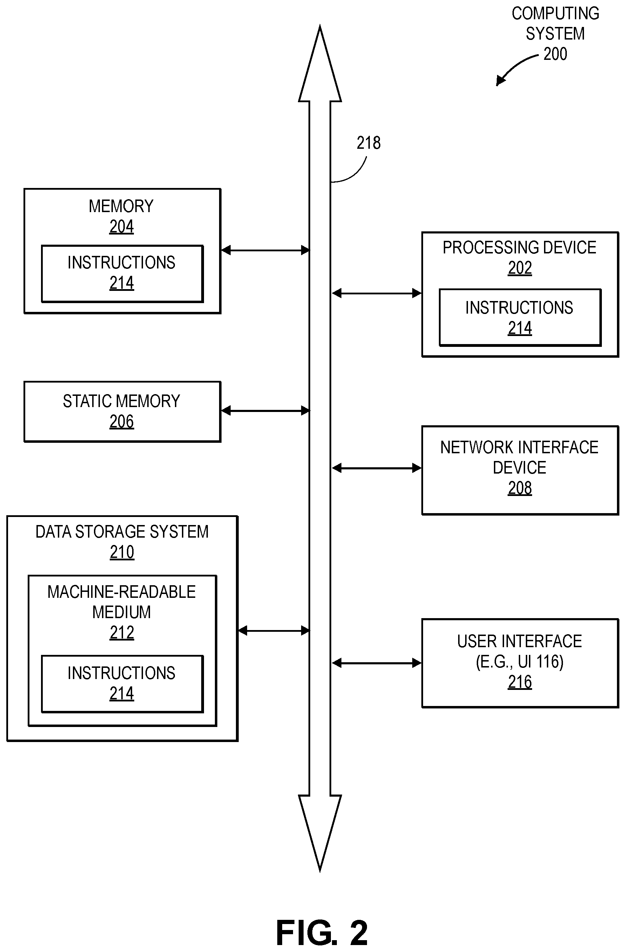

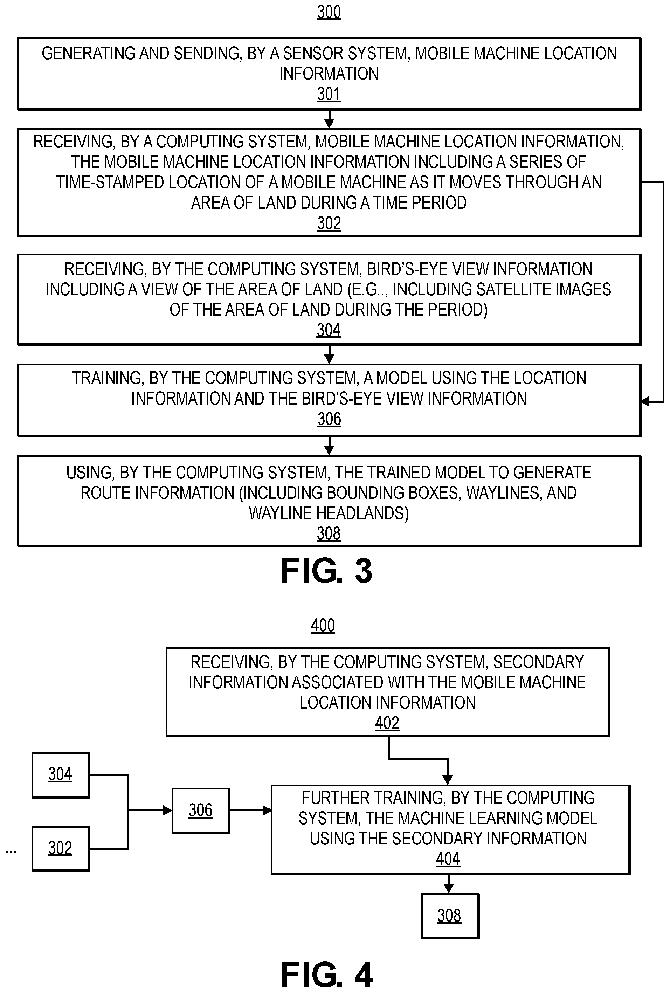

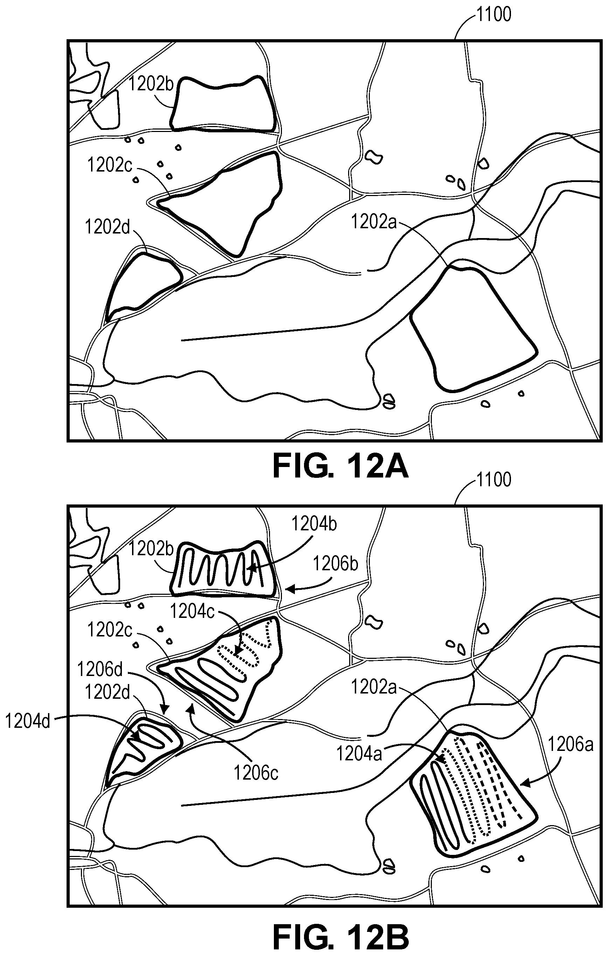

For example, some embodiments include a method for generating routing plans of mobile machines and generating and displaying a related graphical user interface (GUI). In some examples, the method includes receiving, by a computing system (e.g., see computing system 102 or 200 shown in FIGS. 1 and 2 respectively), mobile machine location information (e.g., see location information 104 shown in FIG. 1). The mobile machine location information including a series of time-stamped locations of a mobile machine (e.g., see machine 110) as it moves through an area of land during a time period (e.g., see step 302 of method 300 shown in FIG. 3). The mobile machine including an implement used for farming, construction, or forestry. The method also includes receiving, by the computing system, satellite images (e.g., see bird's-eye view information 106) of the area of land (e.g., see step 304 of method 300). The method also includes training, by the computing system, a model (e.g., see model 108) using the mobile machine location information and the satellite images (e.g., see step 306). The method also includes using, by the computing system, the trained model (e.g., see trained model 109b) to determine and generate a model-based bounding box (e.g., see route information 112, and box 1202a shown in FIGS. 12A and 12B) for the area of land (e.g., see step 308). In some examples, the satellite images are from within the time period. In some examples, the method further includes using, by the computing system, the trained model to determine and generate waylines and wayline headlands within the model-based bounding box for the area of land (e.g., see step 308).

In some examples, the method also includes receiving, by the computing system, secondary information (e.g., see secondary information 114) associated with the mobile machine location information (e.g., see step 402 of method 400 shown in FIG. 4). The received secondary information is from within the time period. And, in such examples, the method also includes further training, by the computing system, the model using the received secondary information (e.g., see step 404). In some cases, the received secondary information includes implement usage information from within the time period. Also, the received secondary information can include implement size information of the implement. Further, the received secondary information can include machine size information of the mobile machine.

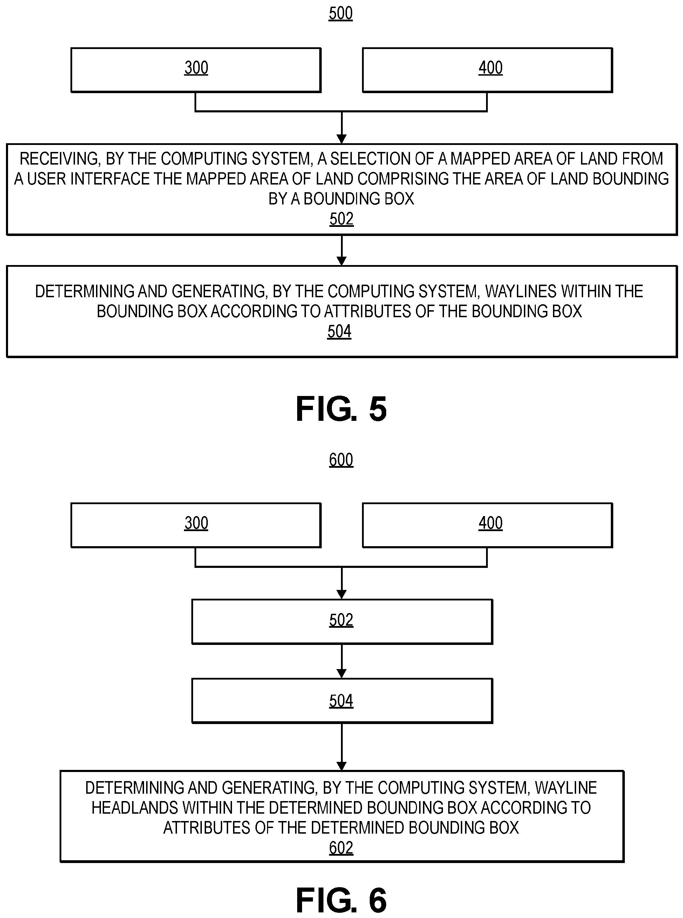

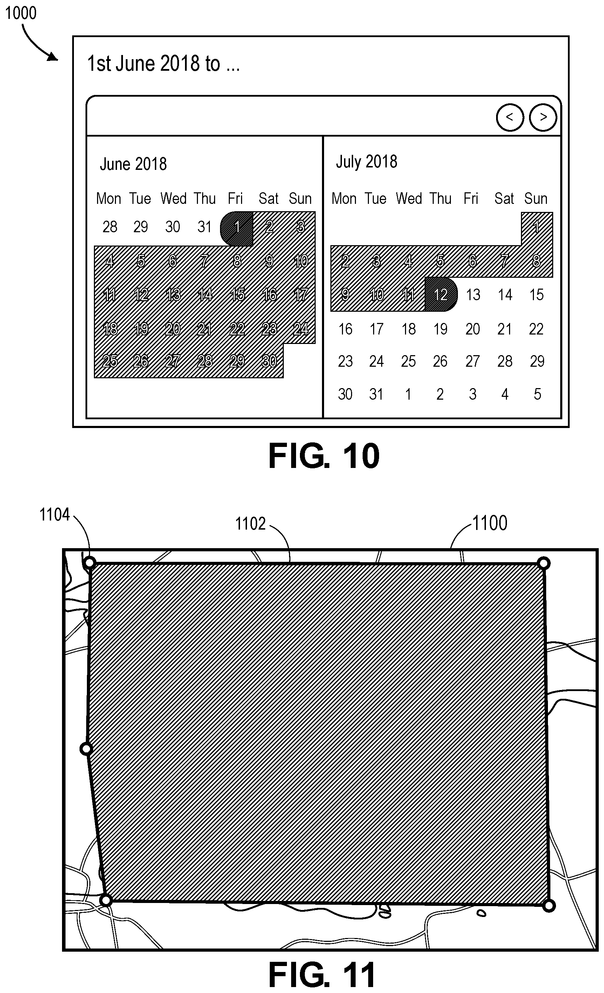

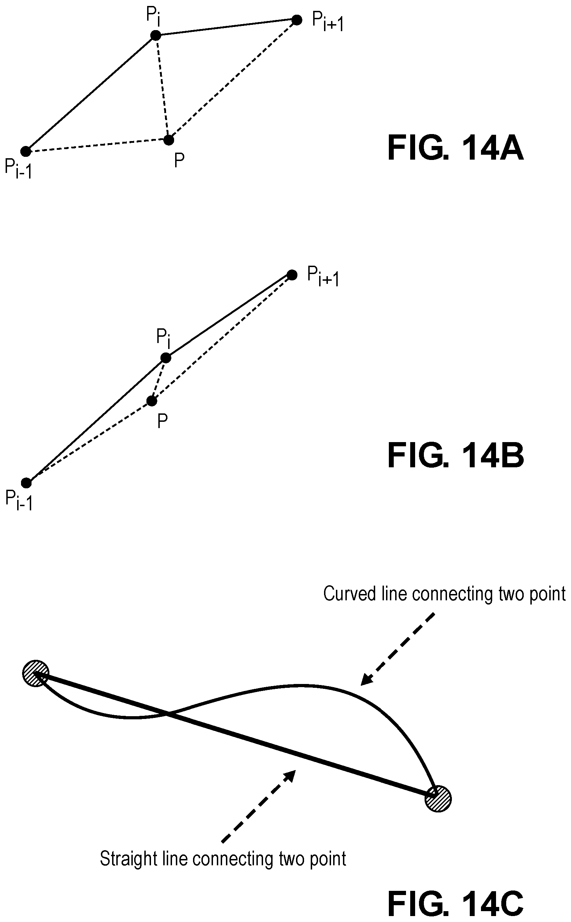

In some examples, the method also includes receiving, by the computing system, a selection of a mapped area of land from a user interface (e.g., see user interface 116, and see GUI element 1100 shown in FIG. 11), the mapped area of land including the area of land bounded by a user-selected bounding box (e.g., see box 1102) (e.g., see step 502 of method 500 shown in FIG. 5). And, in such examples, the method also includes determining and generating, by the computing system, waylines (e.g., see waylines 1204a shown in FIG. 12B) within the model-based bounding box (e.g., see box 1202a) according to attributes of the model-based bounding box (e.g., see step 504). The determination of the waylines can be further executed according to secondary wayline generation factors (e.g., see FIGS. 14A to 18). In some cases, the method also includes determining and generating, by the computing system, wayline headlands (e.g., see headland 1206a) within the model-based bounding box according to attributes of the model-based bounding box (e.g., see step 602 shown of method 600 shown in FIG. 6). The determination of the wayline headlands can be further executed according to secondary wayline generation factors or secondary headland generation factors.

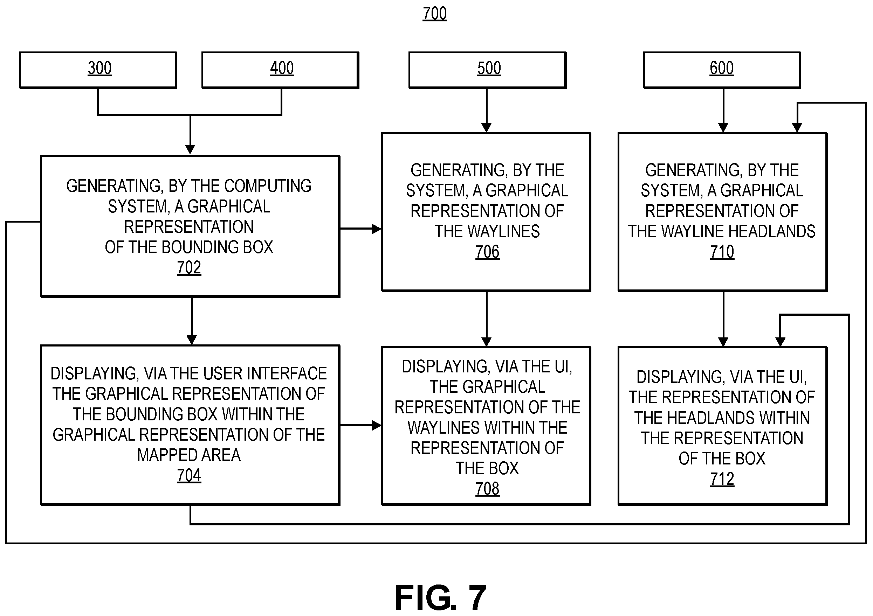

In some examples, the method also includes generating, by the computing system, a graphical representation of the model-based bounding box (e.g., see step 702 of method 700 shown in FIG. 7). The graphical representation of the model-based bounding box is within a graphical representation of the mapped area of land. The method can also include displaying, via the user interface, the graphical representation of the model-based bounding box within the graphical representation of the mapped area of land (e.g., see step 704). The method can also include generating, by the computing system, a graphical representation of the waylines (e.g., see step 706). The graphical representation of the waylines is within the graphical representation of the model-based bounding box (e.g., see box 1202a). The method can also include further displaying, via the user interface, the graphical representations of the waylines within the graphical representation of the model-based bounding box (e.g., see step 708). The method can also include generating, by the computing system, a graphical representation of the wayline headlands (e.g., see headland 1206a) (e.g., see step 710). The graphical representation of the wayline headlands is within the graphical representation of the model-based bounding box. The method can also include further displaying, via the user interface, the graphical representations of the wayline headlands within the graphical representation of the model-based bounding box (e.g., see step 712).

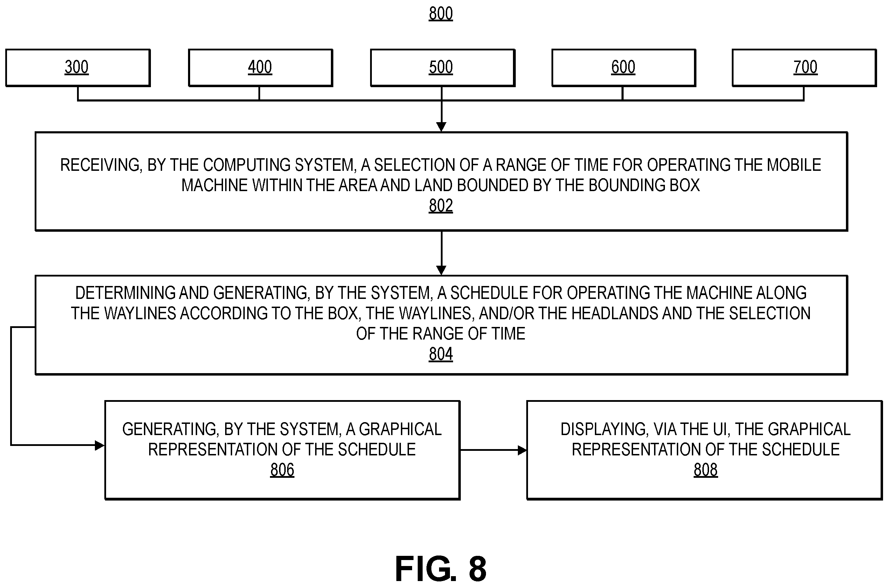

In some examples, the method also includes receiving, by the computing system, a selection of a range of time (e.g., see GUI element 1000) for operating the mobile machine within the area of land bounded by the user-selected bounding box (e.g., see box 1102 shown in FIG. 11, and step 802 of method 800 shown in FIG. 8). The method can also include determining and generating, by the computing system, a schedule (e.g., see GUI element 1300) for operating the machine along the waylines according to the model-based bounding box, the waylines, the headlands, or a combination thereof and the selection of the range of time (e.g., see step 804). The method can also include generating, by the computing system, a graphical representation of the schedule (e.g., see GUI element 1300, and step 806), and displaying, via the user interface, the graphical representation of the schedule (e.g., see step 808).

These and other important aspects of the invention are described more fully in the detailed description below. The invention is not limited to the particular methods and systems described herein. Other embodiments can be used and changes to the described embodiments can be made without departing from the scope of the claims that follow the detailed description. Within the scope of this application, it should be understood that the various aspects, embodiments, examples, and alternatives set out herein, and individual features thereof may be taken independently or in any possible and compatible combination. Where features are described with reference to a single aspect or embodiment, it should be understood that such features are applicable to all aspects and embodiments unless otherwise stated or where such features are incompatible.

**BRIEF DESCRIPTION OF THE DRAWINGS**

The present disclosure will be understood more fully from the detailed description given below and from the accompanying drawings of various example embodiments of the disclosure.

FIG. 1 illustrates an example technical solution to the example technical problems described herein, in accordance with some embodiments of the present disclosure.

FIG. 2 illustrates a block diagram of example aspects of a computing system, in accordance with some embodiments of the present disclosure.

FIGS. 3 to 9 illustrate methods in accordance with some embodiments of the present disclosure.

FIG. 10 to 13 illustrate example GUI elements for routing planning and management, in accordance with some embodiments of the present disclosure.

FIGS. 14A to 17 illustrate secondary wayline generation factors, in accordance with some embodiments of the present disclosure.

FIG. 18 illustrates an example graphical output having a slider bar for adjusting the parameters of the waylines according to tradeoffs, in accordance with some embodiments of the present disclosure.

## DETAILED DESCRIPTION OF EXAMPLE EMBODIMENTS

Details of example embodiments of the invention are described in the following detailed description with reference to the drawings. Although the detailed description provides reference to example embodiments, it is to be understood that the invention disclosed herein is not limited to such example embodiments. But to the contrary, the invention disclosed herein includes numerous alternatives, modifications, and equivalents as will become apparent from consideration of the following detailed description and other parts of this disclosure.

Described herein are improved methods and systems to generate routing plans for mobile machines, such as farming machines, and related graphical user interfaces (GUIs). Also, described herein are techniques for using machine learning to generate routing plans of mobile machines. The mobile machines can be or include mobile agricultural machines, mobile construction machines, mobile forestry machines, or mobile landscaping machines, for example. The techniques disclosed herein provide specific technical solutions to at least overcome the technical problems mentioned in the background section or other parts of the application as well as other technical problems not described herein but recognized by those skilled in the art.

As mentioned, having an accurate field boundary is useful for modern-day farming and other types of operations that occur within larger land areas. For example, in precision farming, the field boundary usually must be known to devise a plan for a farming task. The boundary can be useful to generate waylines, for instance. However, in many countries, a database of fields does not exist, and therefore the farmers need to create these field boundaries on their own. This leads to inaccurate boundaries often; and therefore, waylines and routes are commonly less efficient than they should be. Typically, farmers use satellite images. However, creating the field boundary using only satellite image data usually leads to an uncertainty of the boundary and can harm the planning of operations. On the other hand, to reduce the uncertainty by only using satellite images to find the field boundary, the satellite images can be combined with historic GPS-signal data or location information (more generally speaking) from one or more mobile machines. The historical GPS data can be processed by a data handling process (such as a process using machine learning). Then, turns and waylines can be labeled, and the headland and primary area can be found. Optionally, with the knowledge of the operations of the machine or other machine parameters such as implement size, the system can make a more accurate assessment. A minimum-sized bounding box can then be fitted around the headland and waylines. This can assist in minimizing overlap in waylines and turns in routes and make for more efficient use of mobile machines at a work site or in a field. In some examples, an operator can indicate the general area of interest via a user-selected bounding box together with a start and end date from a calendar view (e.g., see FIGS. 10 and 11). The system can then automatically detect fields within the user-selected box according to some parameters and provide another graphical user interface (GUI) element that displays system-generated bounding boxes within the area (e.g., see FIG. 12A). The system can also automatically add respective waylines and headlands to the system-generated bounding boxes to give an overview of routes visually for an operator to review (e.g., see FIG. 12B). Also, the system can provide a graphically rendered schedule for the operator to follow derived from the route information (the route information including the waylines and headlands). These are just some examples of the benefits of the disclosed techniques.

Also, as mentioned, it is known to perform path planning for various operations. Such planning is often performed manually by the operator of machines. More recently, computing systems have been developed that suggest operational paths to an operator based on an operational task, field slope, etc.; however, there is much room for improvement on such systems in that such systems are not sophisticated enough to consider complex interaction between various factors. On the other hand, the techniques described herein provide example improvements to such systems and beyond that they go beyond manual planning, expert knowledge, and simple computations (e.g., heuristic algorithms) and can consider the complex interactions between various factors, such as terrain, ground conditions, soil type, weather conditions, and machinery capabilities. With the complex interactions being considered by the novel techniques described herein, example technical problems can be resolved. For example, the technologies described here can avoid determinations of subpar paths with increased fuel consumption that ultimately result in higher operational costs and reduced productivity. And, these are just some other examples of the benefits of the disclosed techniques.

Furthermore, the technologies described herein can leverage advancements in artificial intelligence (AI), machine learning, and deep learning, which makes it possible to develop more sophisticated route planning systems capable of considering a multitude of factors and making enhanced decisions from those made by the prior art.

For example, some of the embodiments leverage machine learning or deep learning for generating field boundaries and then routes. In some embodiments, a method includes receiving, by a computing system (e.g., see computing systems 102 and 200 shown in FIGS. 1 and 2 respectively), mobile machine location information (e.g., see information 104 shown in FIG. 1 and step 302 shown in FIG. 3. The information including a series of time-stamped locations of a mobile machine (e.g., see mobile machine 110) as it moves through an area of land during a time period. The machine can include an implement used for farming, construction, or forestry. The method also can include receiving, by the system, satellite images of the area (e.g., see information 106, and step 304). The method can also include training, by the system, a model (e.g., see model 108) using the information and the images (e.g., see step 306). The method can also include using, by the system, the trained model (e.g., see trained model 109b) to generate a model-based bounding box (e.g., see box 1202a shown in FIGS. 12A and 12B and information 112) for the area (e.g., see step 308). The method can also include generating, by the system, a graphic of the box (e.g., see step 702 shown in FIG. 7 and box 1202a). The box graphic can be generated within a graphical mapped area of land. And, the method can include displaying, via a GUI (e.g., see UIs 116, 216, 1100), the box graphic within the graphical mapped area (e.g., see step 704). Also, waylines and wayline headlands can be generated to be within the box and displayed with the box via the GUI (e.g., see FIGS. 7 and 12B).

For the sake of this disclosure, it is to be understood that any bounding box described herein can have the shape of any type of polygon. Also, for the sake of this disclosure, it is to be understood that any bounding box described herein does not have to be a polygon by definition but can be defined by a two-dimensional closed shape bounded with straight or curved sides or edges. For the sake of this disclosure, a polygon is defined as a two-dimensional closed shape bounded with straight sides; and, the sides of a polygon are also called its edges. The points where two sides meet of a polygon are referred to herein as vertices or corners of a polygon.

The technologies can use deep learning models, based on Recurrent Neural Networks (RNNs) or Long Short-Term Memory (LSTM) networks, for example, or Transformer-based models. Such models can generate plans that consider many factors in sequence-based tasks, such as making plans suitable for route planning applications. Combined with GPS technology and the increasing digitization of mobile machinery, large amounts of data have become collectible to facilitate the creation and training of such models. The collected data can be used to train deep learning models, allowing them to learn complex patterns and dependencies between a multitude of factors, including waylines, distances, and other relevant features of a work site or field, as well as complex interactions between various factors, such as terrain, ground conditions, soil type, weather conditions, and machinery capabilities. Also, the models described herein can predict enhanced routes for mobile machines, which consider various efficiencies and factors such as operational time efficiency, fuel efficiency, reduced soil compaction, and machine capabilities. The application of deep learning-based route planning in agricultural, construction, forestry, landscaping, and other settings has the potential to revolutionize the way corresponding businesses operate. By leveraging AI machine learning, and deep learning to enhance routes, operators of mobile machines can reduce costs, improve efficiency, and minimize the environmental impact of their operations.

FIG. 1 illustrates an example technical solution to the example technical problems described herein. The technical solution, shown in FIG. 1, can include or be a part of the techniques and technologies described herein (such as any one of the methods 300, 400, 500, 600, 700, 800, and 900 shown in FIGS. 3, 4, 5, 6, 7, 8, and 9 respectively) and can provide specific technical solutions to at least overcome the technical problems mentioned in the background section or other parts of the application as well as other technical problems not described herein but recognized by those skilled in the art.

FIG. 1 depicts a network 100, such as a computer network, within which a computing system 102 receives various inputs (e.g., see machine location information 104, bird's-eye view information 106, and secondary information 114). These inputs and others can be received from other computing systems within the network 100 or from sensor systems in the network. The various inputs include or are related to some of the efficiencies and factors (such as operational time efficiency, fuel efficiency, reduced soil compaction, and machine capabilities) that are considered by the computing system in route planning and the determination of routes within a field. As shown, the computing system includes a model 108 that can be trained through various machine learning and deep learning techniques (e.g., see training 109a), and the result of the training provides a trained model 109b. Once the model is trained (e.g., see trained model 109b), it can be used to generate route information 112 for route planning within a field. As shown, the route information 112 is an output of the trained model 109b and can be an input for user interface 116 to be used to some extent in a GUI provided by UI 116. In some cases, the route information 112 includes computed bounding box information, waylines, and wayline headlands.

In some embodiments, the technologies use a machine learning or deep learning based model to assist in the tracking of mobile machine operational statuses at intervals of time of a time period. Thus, in some embodiments, the model 108 includes a machine learning or deep learning model. Also, in some examples, the technologies described herein can leverage another type of model that is not trained via machine learning or deep learning, such as a predetermined and static rules-based model for route planning. Furthermore, in some examples, the technologies described herein can use a model that is trained or frequently updated by a computing technique or other type of technique other than machine learning or deep learning, such as a dynamic rules-based model for route planning.

Also, as shown, the computing system 102 is a part of a mobile machine 110 or the network 100 depending on the embodiment as are the inputs and outputs of the computing system (including the inputs of the model 108 and the output of the trained model 109b). In some embodiments, the computing system 102 and the inputs and outputs of the computing system are part of a remote system in that the remote system is physically and geographically separated from the mobile machine 110 but communicates with a system or controller of the machine over a telecommunications or computer network (such as network 100). The mobile machine 110 can be or include an agricultural machine, a construction machine, a forestry machine, or a landscaping machine. The mobile machine 110 can also be configured to follow routing instructions entirely or to some extent via a control system (e.g., see route information 112 which can include routing instructions).

The computing system 102 includes electronics such as one or more controllers, sensors, busses, and computers. The computing system 102 includes at least a processor, memory, and a communication interface and can include one or more sensors, which can make the mobile machine 110 an individual computing device. In the case of the network 100 including the Internet, the mobile machine 110 can be considered an Internet of Things (IoT) device. Also, in some embodiments, the computing system 102 is a part of a cloud computing system. The computing system 102 and the mobile machine 110 can include both electronic hardware and software that can integrate between the systems of the computing system and the mobile machine 110. And, such hardware and software (such as controllers and sensors and other types of electrical and/or mechanical devices) can be configured to a communicate with a remote computing system via the communications network 100.

In some embodiments, where the mobile machine 110 is an agricultural machine, it can include or be a combine harvester, a tractor, a planter, a sprayer, a baler, etc. In some embodiments, where the mobile machine 110 is a construction machine, it can include or be an excavator, a compaction machine (such as one with rollers), a loader, a bulldozer, a skid steer machine, a grader, etc. In some embodiments, where the mobile machine 110 is a forestry or landscaping machine, it can include or be a delimber, a feller buncher, a stump grinder, a mulcher, a yarder, a forwarder, log loader, a harvester, etc. In some embodiments, the mobile machine 110 can be or include a vehicle in that it is self-propelling. Also, in some embodiments, the mobile machine 110 can be a part of a group of similar machines or a group of different types of mobile machines.

The network 100 can include one or more local area networks (LAN(s)) and/or one or more wide area networks (WAN(s)). In some embodiments, the network 100 includes the Internet and/or any other type of interconnected communications network. The network 100 can also include a single computer network or a telecommunications network. More specifically, in some embodiments, the network 100 includes a local area network (LAN) such as a private computer network that connects computers in small physical areas, a wide area network (WAN) to connect computers located in different geographical locations, and/or a middle area network (MAN) to connect computers in a geographic area larger than that covered by a large LAN but smaller than the area covered by a WAN.

At least each shown component of the network 100 (including computing system 102) can be or include a computing system that includes memory that includes media. The media includes or is volatile memory components, non-volatile memory components, or a combination thereof. In general, in some embodiments, each of the computing systems includes a host system that uses memory. For example, the host system writes data to the memory and reads data from the memory. The host system is a computing device that includes a memory and a data processing device. The host system includes or is coupled to the memory so that the host system reads data from or writes data to the memory. The host system is coupled to the memory via a physical host interface. The physical host interface provides an interface for passing control, address, data, and other signals between the memory and the host system.

In some examples, the mobile machine location information 104 includes a series of time-stamped locations of the mobile machine 110 as it moves through an area of land during a time period. As shown, the location information 104 is received from some of the sensors 102c. In some embodiments, the linking of the geographic location (e.g., GPS coordinates) of the mobile machine 110 to a date and time (such as via a timestamp) includes geotagging the date and time or the time stamp. Such tagging can include adding geographical identification metadata to an item including the image or a file of data that has date and time information associated with it. In some embodiments, the metadata can be embedded in the image or the item. And, in some embodiments, the metadata is stored separately and linked to the image or the item. The item can be a data log, a control system or sensor output signal, an image file, an image stream, an image object, etc. Also, in some embodiments, the item is a data log, a control system or sensor output signal, an image file or a video file, a media feed, a message file, or another type of item that is configurable to include a time and date information such as a timestamp and that can be geotagged. And, in some embodiments, the metadata related to the geotag includes latitude and longitude coordinates, altitude, bearing, distance, accuracy data, a place name, and/or a time stamp.

In some embodiments, the computing system 102 can link the mobile machine location information 104 to the other types of information of the system (e.g., bird's-eye view information 106, route information 112, and secondary information 114) via identifiers of parts of the information, which can become a part of the metadata before or after being linked to the location information 104. This makes the geotagging advanced geotagging. In some embodiments, a location tracking system configured to retrieve at least part of the location information 104 includes a GPS or is part of a GPS (e.g., which can be one or more of the sensors of the mobile machine 110). In some embodiments, a camera is attached to the mobile machine 110 and the camera can record information about or near the machine such as some of the secondary information 114; and, the location tracking system can geotag the information 106, 112, and 114.

In some examples, the bird's-eye view information 106 includes images from above of work sites or fields captured by cameras of a satellite in orbit. In some cases, the bird's-eye view information 106 includes images from above of work sites or fields captured by cameras of a drone flying above the work sites or fields. In some cases, the weather data can be part of bird's-eye view information 106 and the weather data can include one or more datasets collected from one or more satellites, radiosondes, etc. Also, in some examples, with the addition of satellite or drone images (such as used by the normalized difference vegetation index or NDVI) as part of the information 106, a prediction of the crop state can be made and routes can be generated or updated accordingly (such as by part of the model 108). This can assist in narrowing the type of field operation or the status of it which can be used to route plan. For example, if the NDVI can show that there is no vegetation in a field, then it may be concluded that the operation is not a spraying operation and the route information would be generated accordingly via the model.

In some examples, the route information 112 includes information regarding routes for fields and work sites as well as complementary information corresponding to routes such as environmental or mobile machine operations factors, parameters, variables, and conditions that can be derived from the secondary information 114. Also, the route information 112 can include model-generated bounding boxes, waylines, route turns, spacing between waylines, more optimal scheduling parameters, and wayline headlands, for example. Also, the route information can include primary and secondary factors and constraints to generate routes via the trained model 109b. For instance, the information 112 can include a steering angle constraint (e.g., a curvature constraint) of a mobile machine that can be used by the system to generate waylines producing minimum possible overlap with adjacent waylines while reducing that amount and extent of skipped areas of the field or work site.

In some examples, the secondary information 114 includes machine operation information that can include machine operation signals of the mobile machine 110 that include machine operations data related to operations of the mobile machine. The machine operation information can be received from sensors, for example. The machine operation information can relate to implement positions or heights. In some embodiments, the machine operation information can include one or more of the implement or actuator operation speeds or rates. In some embodiments, machine operation information can include one or more of dispensing rates, evacuation rates, flow rates, spray rates, seeding rates, or some combination thereof. In some embodiments, the machine operation information includes one or more of mobile machine default ground speeds, mobile machine maximum ground speeds, mobile machine minimum ground speeds, or some combination thereof. In some embodiments, the machine operation information includes one or more of default hydraulic pressures, maximum hydraulic pressures, or minimum hydraulic pressures, or one or more of default operating temperatures or pressures, maximum operating temperatures or pressures, or minimum operating temperatures or pressures, or some combination thereof.

Depending on the embodiment, an implement can include one or more of any hydromechanical or electromechanical work tools such as augers, backhoes, bale spears, brooms, bulldozer blades, clamshell buckets, cold planes, demolition shears, equipment buckets, excavator buckets, forks, grapples, hammers, hoe rams, tilting buckets (such as 4-in-1 buckets), landscape tillers, material handling arms, mechanical pulverizers, crushers, multi-processors, pavement removal buckets, pile drivers, power take-offs, quick couplers, rakes, rippers, rotating grabs, compactors, skeleton buckets, snow blowers, stump grinders, stump shears, thumbs, tiltrotators, trenchers, vibratory plate compactors, wheel saws. Or, depending on the embodiment, an implement can include one or more of farming implements such as implements that till the ground (e.g., plows, offset discs, chisels, etc.), plant seeds, or transplant seedlings (e.g., seeders, planters, transplanters, etc.), harvest crops (e.g., reapers, threshers, gatherers, winnowers, or combines), bale, or perform other farming tasks such as spraying crops (e.g., sprayers). Or, depending on the embodiment, an implement can include one or more of forestry or landscaping implements such as axes, saws, mowers, or implements for tree planting or afforestation, mensuration, fire suppression, or logging or for other forestry or landscaping functions or tasks.

In some examples, the secondary information 114 includes environmental factors occurring during a time period associated with the operations of the mobile machine. In some examples, the environmental factors include at least one of wind speed, wind direction, temperature, humidity, daytime duration, and cloud cover. In some cases, the environmental factors include crop type. In some embodiments, the secondary information 114 includes one or more of field crop information, wind direction or speed, ambient temperature, ambient humidity, soil characteristics, time of day, date, and geographic region. In some embodiments, the field crop information includes one or more of crop heights, crop color, crop moisture, crop lodging, and weed information. In some embodiments, the mobile machine is a harvester and the secondary information includes one or more of ground speed, fuel efficiency, crop throughput, crop quality (e.g., crop quality can include the number of kernels of grain that are cracked or broken), crop cleanliness, and crop yield. In some cases, the secondary information 114 includes field information having one or more of field size information, field shape information, field elevation information, field topology information, soil type information, soil condition information, crop type information, crop lodging information, soil compaction information, weed density information, and weed location information. In some embodiments, the field information is recorded field information recorded from one or more fields, or the field information is predetermined or preselected field information from known field attributes, or some combination thereof.

In some embodiments, the secondary information 114 includes weather data, ambient condition data, time of year data, geographic region data, or any combination thereof. In some cases, the secondary information 114 includes weather data that includes one or more of datasets collected from one or more of thermometers, barometers, radar, wind vanes, anemometers, transmissometers, hygrometers, etc. The datasets can include measured temperature, air pressure, rain or snow locations, wind direction, wind speed, atmospheric visibility, humidity, etc. In some cases, the weather data includes one or more datasets collected from one or more satellites, radiosondes, etc.

The secondary information 114 can be used as input for the user interface 116. Also, the secondary information 114 can be used as input for training the model. The secondary information 114 as well as any other information used as input for the model 108 that comes from complex data sources such as images can be derived in part from feature extractions. Feature extractions can include extracting relevant features from the information containing environmental factors, machine operating conditions, machine statuses and machine parts statuses, the machine settings, or recorded results of operations. And, the model or type of model to be used can be determined based on or prior to the feature extractions. The model selection can include choosing a suitable machine learning model or deep learning model, such as a deep learning model for sequence-based data, such as recurrent neural networks (RNNs), long short-term memory (LSTM) networks, or transformer-based models. Such models are capable of capturing temporal dependencies and learning complex patterns in the data. In some embodiments, the trained model 109b includes at least one of RNNs, LSTM networks, or transformer-based models. In some embodiments, the training 109a or any of the training that occurs in the steps of methods described herein is according to preprocessed data that includes the extracted features from the feature extraction as input sequences.

The model evaluation or selection can be a part of any one of the methods described herein. The selection of a model would occur prior to use of the model 108. In some examples, the evaluation can include the evaluation of the trained model's performance on a dataset to ensure its generalization is valid to unseen data (e.g., evaluating the trained model 109b). The evaluation can use metrics, such as mean absolute error, root mean squared error, or custom metrics relevant to the specific application. The methods described herein can include model deployment. The deployment can include integrating the trained model into the mobile machine's UI systems. For example, the deployment can include integrating the trained model into the mobile machine's UI systems to provide real-time updates and enhancements to the information provided via the UI systems such as for route planning and optimization of machine operations and settings.

In some embodiments, the model 108 can benefit from continuous improvement such as regularly updating the model with new data to ensure its performance remains accurate and up-to-date. For example, any of the model inputs described herein can be used for regularly updating the model as can any of the outputs of the model or derivatives thereof be used. Also, improving the model can include monitoring the model's performance and retraining or fine-tuning the model per application of it or as needed accordingly. By implementing deep learning-based machine operations, statuses, settings, and routing determinations, the technologies described herein can assist in the planning and control of mobile machines. With such technologies, it is possible to use machine learning to (1) plan future operations, (2) control mobile machines, (3) adjust the settings of mobile machines in real time, and (3) generate, update, enhance, or schedule settings or operations in general. And, the aforesaid features can be implemented for various factors, such as operational time efficiency, fuel efficiency, reduced soil compaction, and machine capabilities. This can lead to improved productivity, cost savings, and better overall sustainability of operations.

Alternatively, a less costly or less computing resource intensive approach can be used to generate or update the model 108. And, such an approach can reduce the use of resources by not using machine learning or deep learning processes. In some examples, the technologies described herein can leverage another type of model for model 108 that is not trained via machine learning or deep learning, such as a predetermined and static rules-based model for route planning. Furthermore, in some examples, the technologies described herein can use a model that is trained or frequently updated by a computing technique or other type of technique other than machine learning or deep learning, such as a dynamic rules-based model for route planning.

In some embodiments, the model includes an artificial neural network. Also, in some examples, the model can include deep learning-based determinations for routing purposes or can include an output of machine operational statuses that can be used for further analysis or for even controlling mobile machines or adjusting settings of mobile machines. By leveraging the power of deep learning, a model can capture complex patterns and dependencies within various data inputs into the model, allowing for more efficient route planning and machine status and settings determinations, scheduling, and execution, even in real time when the machine is operating. In order to leverage ANNs or deep learning processes some embodiments preprocess the inputs to the model (e.g., including inputs described with respect to methods 300 to 800 as well as inputs including machine location information 104, bird's-eye view information 106, and secondary information 114).

FIG. 2 illustrates a block diagram of example aspects of a computing system 200 that can implement the technical solution shown in FIG. 1 or each main part of the solution. Also, FIG. 2 illustrates parts of the computing system 200 within which a set of instructions are executed for causing a machine (such as a computer processor or processing device 202) to perform any one or more of the methodologies discussed herein performed by a computing system (e.g., see the method steps of the methods 300, 400, 500, 600, 700, 800, and 900 shown in FIGS. 3, 4, 5, 6, 7, 8, and 9 respectively). In some embodiments, the computing system 200 operates with additional computing systems to provide increased computing capacity in which multiple computing systems operate together to perform any one or more of the methodologies discussed herein that are performed by a computing system.

In some embodiments, the computing system 200 corresponds to a host system that includes, is coupled to, or utilizes memory or is used to perform the operations performed by any one of the computing systems described herein. In some embodiments, the machine is connected (e.g., networked) to other machines in a LAN, an intranet, an extranet, or the Internet. In some embodiments, the machine operates in the capacity of a server in a client-server network environment, as a peer machine in a peer-to-peer (or distributed) network environment, or as a server in a cloud computing infrastructure or environment. In some embodiments, the machine is a personal computer (PC), a tablet PC, a cellular telephone, a web appliance, a server, or any machine capable of executing a set of instructions (sequential or otherwise) that specify actions to be taken by that machine. Further, while a single machine is illustrated, the term "machine" shall also be taken to include any collection of machines that individually or jointly execute a set (or multiple sets) of instructions to perform any one or more of the methodologies discussed herein performed by computing systems.

The computing system 200 includes a processing device 202, a main memory 204 (e.g., read-only memory (ROM), flash memory, dynamic random-access memory (DRAM), etc.), a static memory 206 (e.g., flash memory, static random-access memory (SRAM), etc.), and a data storage system 210, which communicate with each other via a bus 218. The processing device 202 represents one or more general-purpose processing devices such as a microprocessor, a central processing unit, or the like. More particularly, the processing device can include a microprocessor or a processor implementing other instruction sets, or processors implementing a combination of instruction sets. Or, the processing device 202 is one or more special-purpose processing devices such as an application-specific integrated circuit (ASIC), a field programmable gate array (FPGA), a digital signal processor (DSP), a network processor, or the like. The processing device 202 is configured to execute instructions 214 for performing the operations discussed herein performed by a computing system. In some embodiments, the computing system 200 includes a network interface device 208 to communicate over a communications network. Such a communications network can include one or more local area networks (LAN(s)) and/or one or more wide area networks (WAN(s)). In some embodiments, the communications network includes the Internet and/or any other type of interconnected communications network. The communications network can also include a single computer network or a telecommunications network.

The data storage system 210 includes a machine-readable storage medium 212 (also known as a computer-readable medium) on which is stored one or more sets of instructions 214 or software embodying any one or more of the methodologies or functions described herein performed by a computing system. The instructions 214 also reside, completely or at least partially, within the main memory 204 or within the processing device 202 during execution thereof by the computing system 200, the main memory 204 and the processing device 202 also constituting machine-readable storage media. While the machine-readable storage medium 212 is shown in an example embodiment to be a single medium, the term "machine-readable storage medium" should be taken to include a single medium or multiple media that store the one or more sets of instructions. The term "machine-readable storage medium" shall also be taken to include any medium that is capable of storing or encoding a set of instructions for execution by the machine and that causes the machine to perform any one or more of the methodologies of the present disclosure performed by a computing system. The term "machine-readable storage medium" shall accordingly be taken to include solid-state memories, optical media, or magnetic media.

Also, as shown, the computing system 200 includes user interface 216 (which can include UI 116 shown in FIG. 1) that includes a display, in some embodiments, and, for example, implements functionality corresponding to any one of the UI devices disclosed herein. A user interface or UI, such as UI 216, or a UI device described herein includes any space or equipment where interactions between humans and machines occur. A UI described herein allows operation and control of the machine from a human user, while the machine simultaneously provides feedback information to the user. Examples of a user interface, or UI device include the interactive aspects of computer operating systems (such as GUIs), machinery operator controls, and process controls.

FIGS. 3 to 9 illustrate methods in accordance with some embodiments of the present disclosure. Methods 300, 400, 500, 600, 700, 800, and 900 of the corresponding figures are performed by any one of the computing systems described herein (e.g., see computing system 102 or 200 depicted in FIGS. 1 and 2 respectively). In some systems of the technologies disclosed herein, any steps of embodiments of the methods described herein are implementable by executing instructions corresponding to the steps, which are stored in memory (such as the instructions 214).

As shown in FIG. 3, method 300 begins with step 301, which includes generating and sending, by a sensor system of a mobile machine (e.g., see mobile machine 110 depicted in FIG. 1), mobile machine location information (e.g., see mobile machine location information 104). The method 300, at step 302, continues with receiving, by a computing system (e.g., see computing systems 102 and 200 shown in FIG. 1 and 2 respectively), the mobile machine location information. The mobile machine location information can include a series of time-stamped locations of a mobile machine as it moves through an area of land during a time period. The mobile machine can include an implement used for farming, construction, or forestry.

At step 304, the method 300 also includes receiving, by the computing system, bird's-eye view information of the area of land, such as satellite images of the area of land (e.g., see bird's-eye view information 106). At step 306, the method 300 includes training, by the computing system, a model (e.g., see model 108) using the mobile machine location information and the bird's-eye view information. At step 308, the method 300 includes using, by the computing system, the trained model (e.g., see trained model 109b) to determine and generate route information (including bounding boxes, waylines, and wayline headlands). In some examples, at step 308, the method includes using, by the computing system, the trained model to determine and generate a model-based bounding box for the area of land. With respect to some examples and step 308, satellite images of the bird's-eye view information are from within the time period.

As shown in FIG. 4, method 400 includes steps from method 300, including steps 302, 304, and 306, and the method 400 includes step 402 which includes receiving, by the computing system, secondary information (e.g., see secondary information 114) associated with the mobile machine location information. In some cases, the received secondary information is from within the time period. At step 404, the method 400 includes further training, by the computing system, the model using the received secondary information.

In some embodiments of the methods described herein, the received secondary information includes implement usage information from within the time period. In some embodiments of the methods described herein, the received secondary information includes implement size information of the implement. In some embodiments of the methods described herein, the received secondary information includes machine size information of the mobile machine.

As shown in FIG. 5, method 500 includes steps from the method 300 or the method 400, and the method 500 includes step 502 which includes receiving, by the computing system, a selection of a mapped area of land from a user interface (e.g., see UI 116 depicted in FIG. 1 which can be the means for receiving the selection of the mapped area, and see GUI element 1100, depicted in FIG.11, which is shown including a selection of a mapped area of land of a GUI). The mapped area of land can include the area of land bounded by a user-selected bounding box (e.g., see user-selected bounding box 1102 shown in FIG. 11). At step 504, the method 500 includes determining and generating, by the computing system, waylines (e.g., see waylines 1204a shown in FIG. 12B) within a model-based bounding box (e.g., see model-based bounding box 1202a) according to attributes of the model-based bounding box. Not depicted, the model-based bounding box can be determined and generated by the model referred to in method 300 or method 400. In some cases, the determination of the waylines is further according to secondary wayline generation factors (e.g., see FIGS. 14A to 18 which illustrate examples of secondary wayline generation factors such as swath width in a field or steering angle constraint, e.g., a curvature constraint, of a mobile machine).

As shown in FIG. 6, method 600 includes steps from the method 300 or the method 400, and the method 500 (including steps 502 and 504). Also, method 600 includes, at step 602, determining and generating, by the computing system, wayline headlands (e.g., see headlands 1206a depicted in FIG. 12B) within the model-based bounding box (e.g., see box 1202a) according to attributes of the model-based bounding box of method 500. In some cases, the determination of the wayline headlands is further according to secondary wayline generation factors (e.g., see FIGS. 14A to 18 which illustrate examples of secondary wayline generation factors such as swath width in a field or steering angle constraint, e.g., a curvature constraint, of a mobile machine) or secondary headland generation factors (e.g., headland width, length, area, topography, etc.).

As shown in FIG. 7, method 700 includes steps from the methods 300, 400, 500, and 600. And, the method 700 includes, at step 702, generating, by the computing system, a graphical representation of the model-based bounding box, wherein the graphical representation of the model-based bounding box is within a graphical representation of the mapped area of land. And, at step 704, the method 700 includes displaying, via the user interface, the graphical representation of the model-based bounding box (e.g., see box 1202a shown in FIGS. 12A and 12B) within the graphical representation of the mapped area of land. At step 706, the method 700 includes generating, by the computing system, a graphical representation of the waylines. The graphical representation of the waylines is within the graphical representation of the model-based bounding box. At step 708, the method includes further displaying, via the user interface, the graphical representations of the waylines (e.g., see waylines 1204a) within the graphical representation of the model-based bounding box (e.g., see box 1202a). At step 710, the method includes generating, by the computing system, a graphical representation of the wayline headlands. The graphical representation of the wayline headlands is within the graphical representation of the model-based bounding box. At step 712, the method includes further displaying, via the user interface, the graphical representations of the wayline headlands (e.g., see wayline headlands 1206a) within the graphical representation of the model-based bounding box (e.g., see box 1202a).

As shown in FIG. 8, method 800 includes steps from the methods 300, 400, 500, 600, and 700. And, the method 800 includes, at step 802, including receiving, by the computing system, a selection of a range of time (e.g., see GUI element 1000 shown in FIG. 10 that specifically displays a selection of a series of days in a calendar view or displays, in general, a selection of a range of time). The selection of time being for operating the mobile machine within the area of land bounded by the user-selected bounding box (e.g., see box 1102 shown in FIG. 11). Also, at step 804, the method 800 includes determining and generating, by the computing system, a schedule (e.g., see GUI element 1300 that includes a displaying of a schedule) for operating the machine along the waylines according to the model-based bounding box, the waylines, the headlands, or a combination thereof and the selection of the range of time. At step 806, the method 800 further includes generating, by the computing system, a graphical representation of the schedule (e.g., see GUI element 1300 that includes the displaying of a schedule for a mobile machine to operate in a field according to a planned route using waylines). And, at step 808, the method continues with displaying, via the user interface, the graphical representation of the schedule.

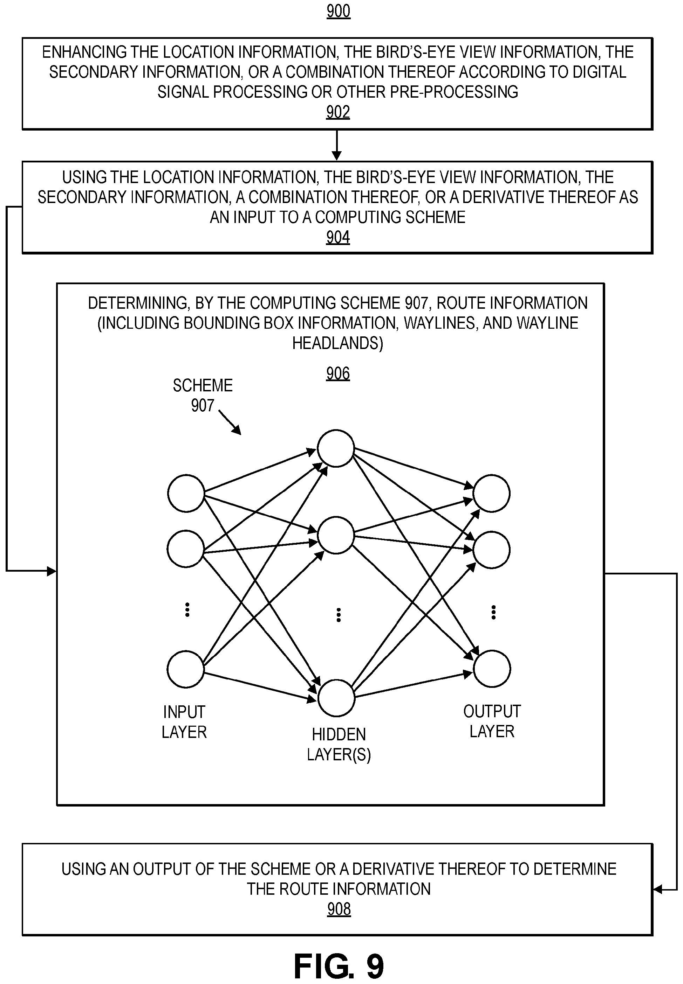

As shown in FIG. 9, a method 900 includes, at step 902, the computing system enhancing the location information, the bird's-eye view information, the secondary information, or a combination thereof according to digital signal processing or other pre-processing. At step 904, the computing system uses the location information, the bird's-eye view information, the secondary information, a combination thereof, or a derivative thereof as an input to a computing scheme 907. At step 906, the computing system specifically determines, by the computing scheme 907, route information (including bounding box information, waylines, and wayline headlands). And, at step 908, the computing system uses an output of the scheme or a derivative thereof to determine the route information (e.g., see route information 112).

Regarding the computing scheme 907 or any other computing scheme described herein, the scheme, in some examples, includes an ANN. And, in some examples, the ANN is part of a deep learning process that determines the status of the mobile machine or is a basis for the determination of the status (e.g., see step 908). The deep learning process, in some examples, includes a CNN or a network of convolutional neural networks CNNs.

For the sake of this disclosure, it is to be understood that any bounding box described herein can have the shape of any type of polygon. Also, for the sake of this disclosure, it is to be understood that any bounding box described herein does not have to be a polygon by definition but can be defined by a two-dimensional closed shape bounded with straight or curved sides or edges. For the sake of this disclosure, a polygon is defined as a two-dimensional closed shape bounded with straight sides; and, the sides of a polygon are also called its edges. The points where two sides meet of a polygon are referred to herein as vertices or corners of a polygon.

FIG. 10 to 13 illustrate example GUI elements 1000, 1100, and 1200 that can be used for routing planning and management, in accordance with some embodiments of the present disclosure. Specifically, FIG. 10 shows GUI element 1000 that is depicted displaying a calendar view of two months and with a user selection of the dates June 1, 2018, through July 12, 2018. As mentioned herein, in some examples, a method includes receiving, by the computing system, a selection of a range of time (which can occur via GUI element 1000) for operating a mobile machine within an area of land bounded by a user-selected bounding box. As an example, FIG. 11 depicts a user-selected bounding box 1102 within GUI element 1100. The box 1102 includes five sides or edges and five vertices or corners of a five-sided polygon. Each corner of the polygon includes a graphical element (e.g., see element 1104) that allows a user to adjust the size and shape of the bounding box within the GUI element 1100. Also, when a user is creating a bounding box, such as the box 1102, this can occur by the user adding the sides of the box to the GUI element one side at a time such that any shape or size of a polygon can be created by a user as long as it fits within the GUI element 1100. FIG. 12A specifically shows model-based bounding boxes 1202a, 1202b, 1202c, and 1202d displayed within the GUI element 1100. The model-based bounding boxes are generated after the user has selected the area of land within the box 1102 and the trained model or another system or process has used that selection to generate the bounding boxes 1202a, 1202b, 1202c, and 1202d. Data corresponding to the generated boxes are then used by the system to generate mobile machine routing within the land areas boxed in by the generated boxes. A depiction of aspects of the routing is specifically shown in FIG. 12B. The aspects of the routing shown in FIG. 12B includes waylines of each route for each box and corresponding wayline headlands (e.g., see waylines 1204a, 1204b, 1204c, and 1204d and wayline headlands 1206a, 1206b, 1206c, and 1206d.

For the purposes of this disclosure, it is to be understood that a headland or a wayline headland is a row or strip of land that is not worked on but proximate to rows or strips of a work site or field where a mobile machine is working, worked, or will work. For instance, a headland can be an unplowed portion at the end of a field or a model-based bounding box of a part of a field.

Also, for the purposes of this disclosure, it is to be understood that any bounding box described herein can have the shape of any type of polygon. Also, for the sake of this disclosure, it is to be understood that any bounding box described herein does not have to be a polygon by definition but can be defined by a two-dimensional closed shape bounded with straight or curved sides or edges. For the purposes of this disclosure, a polygon is defined as a two-dimensional closed shape bounded with straight sides; and, the sides of a polygon are also called its edges. The points where two sides meet of a polygon are referred to herein as vertices or corners of a polygon.

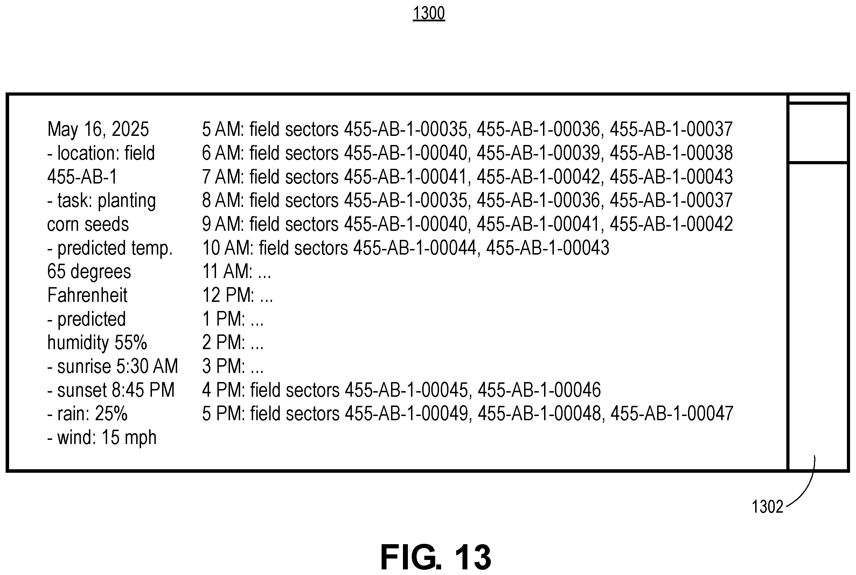

Referring back to FIGS. 10 to 13 as well as method 800, shown in FIG. 8, in some examples, the method 800 includes receiving, by the computing system, a selection of a range of time, which can occur via GUI element 1000. This can be done to plan for operating a mobile machine within an area of land bounded by the user-selected bounding box (e.g., see box 1102 and step 802 of method 800). The method 800 can also include determining and generating, by the computing system, a schedule. An example of such a schedule is depicted in FIG. 13 as being displayed in a list view of GUI element 1300. The list view provides a plan and schedule route for operating the machine along waylines according to the model-based bounding boxes, the waylines, the headlands, or a combination thereof, and the selection of the range of time (e.g., see step 804). Also, as mentioned herein, the method can also include generating, by the computing system, a graphical representation of the schedule (e.g., see GUI element 1300, and step 806), and displaying, via the user interface, the graphical representation of the schedule (e.g., see step 808). Also, as shown in FIG. 13, a user can scroll through the list view of GUI element 1300 by using the scroll bar 1302.

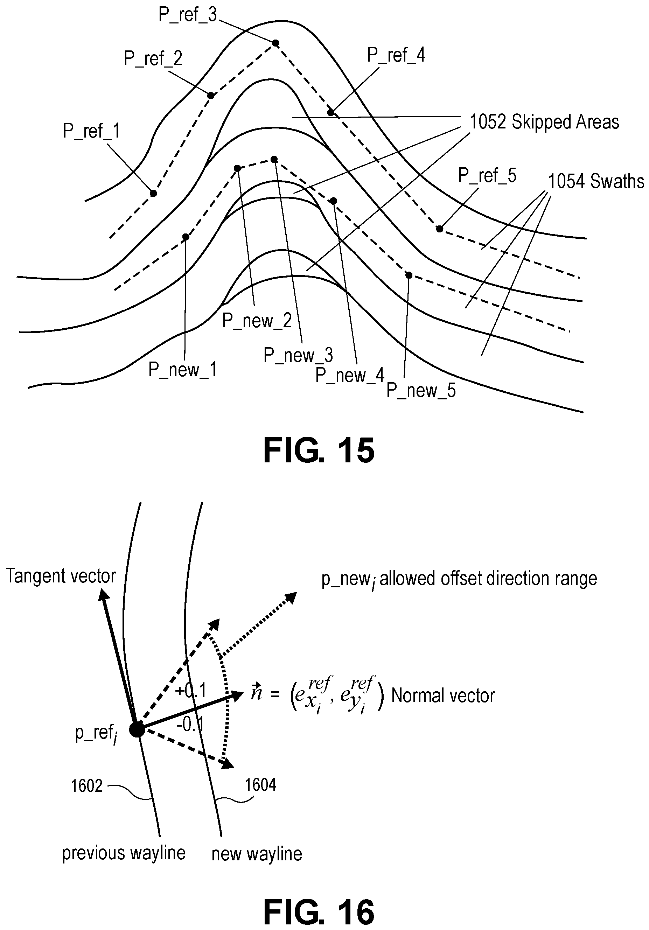

In some embodiments of method 300 as well as some other embodiments, a feature of the method is that it considers a steering angle constraint (e.g., a curvature constraint) of a mobile machine and generates waylines producing minimum possible overlap with adjacent waylines while reducing that amount and extent of skipped areas of the field (e.g., see skipped areas 1502 between swaths 1504 of a field--shown in FIG. 15). A planning method for planning waylines in a route of a mobile machine through a selected area of a field can include any one or more of the steps described herein. And, in some examples, the planning method includes results that exclude skipped areas completely. The generated waylines of the planning method can be used as guidance for a vehicle with an Ackerman mechanism or another type of steering mechanism. The planning method can be formulated as a quadratic programming (QP) problem as provided by the following objective function (or cost function): $min(cost = w1 \cdot cos1 + w2 \cdot cost2 + w3 \cdot cost3)$ (Eq. 1). With some embodiments of the objective function (i.e., Eq. 1), the following equations are used as bases for cost1, cost2, and cost3 of the objective function.

$$cost1 = \sum_{i=1}^{n-1} (x_{i-1} + x_{i+1} - 2x_i)^2 + (y_{i-1} + y_{i+1} - 2y_i)^2 \tag{Eq. 2}$$

$$cost2 = \sum_{i=0}^{n-1} (x_{i+1} - x_i)^2 + (y_{i+1} - y_i)^2 \tag{Eq. 3}$$

$$cost3 = \sum_{i=0}^{n} \left( \left( x_i - (x_i^{ref} + e_{x_i}^{ref} * w) \right)^2 + \left( y_i - (y_i^{ref} + e_{y_i}^{ref} * w) \right)^2 \right) \tag{Eq. 4}$$

And, in such embodiments and some other examples, the following constraints are used with the objective function (i.e., each constraint is represented by an s.t. constraint function).

$$0.8w \le \left( x_i - x_i^{ref} \right) / e_{x_i}^{ref} \le 1.2\, w \tag{Eq. s.t.1}$$

$$0.8w \le \left( y_i - y_i^{ref} \right) / e_{y_i}^{ref} \le 1.2\, w \tag{Eq. s.t.2}$$

$$(x_{i-1} + x_{i+1} - 2x_i)^2 + (y_{i-1} + y_{i+1} - 2y_i)^2 - slack_i \le (\Delta s \times k)^2 \tag{Eq. s.t.3}$$

$$0 \le slack_i \le \infty \tag{Eq. s.t.4}$$

$$e_{y_i}^{ref} / e_{x_i}^{ref} - 0.1 \le \left( y_i - y_i^{ref} \right) / \left( x_i - x_i^{ref} \right) \le e_{y_i}^{ref} / e_{x_i}^{ref} + 0.1 \tag{Eq. s.t.5}$$

Also, in such embodiments and some other examples, the following equation is used.

$$\vec{n} = \left(e_{x_i}^{ref}, e_{y_i}^{ref}\right) \text{is the normal unit vector at point } \left(x_i^{ref}, y_i^{ref}\right) \qquad (\text{Eq. 5})$$

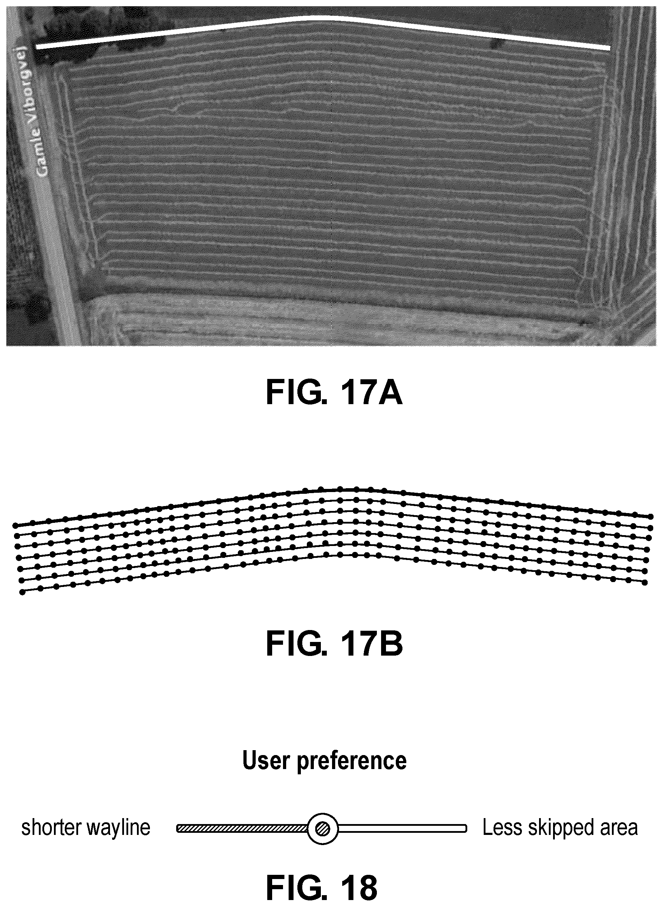

In some embodiments, the geometric interpretation of the objective function of the planning method considers weights w1, w2 and w3--which can be user defined weights, e.g., see FIG. 18. If the operator cares less about one parameter of the set of waylines than another parameter, a lower value can be applied to corresponding one or more weights of the objective function via the slider (e.g., if the operator cares less about skipped area size than wayline length, then a lower value can be given to w3; which coincides with minimization of skipped area being a lower priority than wayline length in the objective functions).

FIGS. 14A and 14B illustrates a modulus(length) of the vector $\overrightarrow{P_iP}$, which is related to cost1 (e.g., see Eq. 2). With cost1, the modulus(length) of the vector $\overrightarrow{P_iP}$, shown in FIGS. 14A and 14B, can be understood as: $|\overrightarrow{P_iP}| = |\overrightarrow{P_iP_{i-1}} + \overrightarrow{P_iP_{i+1}}|$. As $|\overrightarrow{P_iP}|$ gets smaller, the three points $P_{i-1}$, $P_i$, $P_{i+1}$ tends to be on a straight line. In other words, the smaller the $|\overrightarrow{P_iP}|$, the more straight the curve; therefore, the smoother the path. The squared modulus of $\overrightarrow{P_iP} = (x_{i-1} - x_i, y_{i-1} - y_i) + (x_{i+1} - x_i, y_{i+1} - y_i)$ = $(x_{i-1} + x_{i+1} - 2x_i, y_{i-1} + y_{i+1} - 2y_i)$ is $(x_{i-1} + x_{i+1} - 2x_i)^2 + (y_{i-1} + y_{i+1} - 2y_i)^2$.

FIG. 14C illustrates that a straight line is easier to follow than a curved line because it is smoother. This notion relates to cost2 (e.g., see Eq. 3). With respect to Cost2, the plan considers minimizing the total length of a wayline, since a shorter wayline length means a straighter wayline and a straighter wayline means a smoother wayline. As shown in the below figure, the straight line is easier to follow for a mobile machine than the curved line because it is smoother and will have fewer turning angles.

FIG. 15 illustrates that skipped areas 1502 in a set of waylines occur and increase in size with greater curve in a preceding wayline, with respect to a new wayline, in accordance with some embodiments of the present disclosure. FIG. 16 illustrates an example relationship between a previously generated wayline 1602 and a new wayline 1604 generated based on the previously generated wayline, in accordance with some embodiments of the present disclosure. With respect to cost3 (e.g., see Eq. 4), the plan considers or uses minimizing the overlapping of adjacent waylines while achieving the goal of reducing skipped area between adjacent waylines. FIG. 15 illustrates that skipped areas in a set of waylines occur and increase in size with greater curve in a preceding and adjacent wayline, with respect to a new wayline. In some embodiments, the geometric interpretation of the objective function also considers or uses equations s.t.1 and s.t.2. s.t.1 and s.t.2 relate to distance constraint for points of adjacent waylines where distance between each pair of point at adjacent waylines only allow between certain conditions (e.g., 0.8*w and 1*w, w is the working width of the machine). For example, see FIGS. 15 and 16, where it is illustrated that at least two waylines each have multiple waypoints. And, as shown in FIG. 15, p_$new_i$ are wayline points generated based on corresponding point p_$ref_i$ at the reference (or previous) wayline by using a traditional offset method, at least to some extent, which leads to skipped areas between swaths. In objective functions of the methods described herein, the constraint for points of adjacent waylines allows the point p_$new_i$ to freely move (e.g., search a solution) between a given distance (e.g., the given distance 0.8*w and 1*w) with a goal to reduce the skipped area and at the same time to keep the produced overlap between adjacent waylines as much as possible. Note that the distance is the length between p_$new_i$ to its corresponding point p_$ref_i$ at reference (or previous) wayline, and, for example, the previously mentioned values of 0.8 and 1 are adjustable values. Such values can be adjusted through a GUI in some embodiments (see FIG. 18).

In some embodiments, the geometric interpretation of the objective function also considers or uses equation s.t.3, which relates to a curvature $\kappa = 1/R_{min}$ constraint , to make sure the generated wayline satisfies minimum turning radius $R_{min}$ constraint. In some embodiments, the geometric interpretation of the objective function also considers or uses equation s.t.4 to ensure a solution by convergence, and with a slack variable greater than 0 is introduced into the curvature constraint. In some embodiments, the geometric interpretation of the objective function also considers or uses equation s.t.5 as an offset direction constraint. As shown in the below figure, the offset direction to generate next waypoint p_$new_i$ based on the p_$ref_i$ is limited to the range $[\vec{n} - 0.1, \vec{n} + 0.1]$ and the value 0.1 is adjustable. In some embodiments, the geometric interpretation of the objective function also considers that each next new wayline $L_i$ with waypoints p_$new_i$ is generated based on the previous wayline $L_{i-1}$ with waypoints p_$ref_i$. Before generating the next wayline line, the waypoints p_$ref_i$ of previous wayline $L_{i-1}$ is connected by some form of interpolation (e.g., cubic splines, such as cubic B-splines). This is to form a $C^2$ continuous path, which is to get a smooth vehicle path. Also, it is to be understood that such equations and methods can also generate straight A-B waylines when the reference line is straight A-B line.

FIG. 17A illustrates an initial wayline generated for a crop field and FIG. 17B illustrates additional waylines generated based on the initial wayline according to one or more of the equations provided herein (e.g., equations 1, 2, 3, 4, 5, s.t.1, s.t.2, s.t.3, s.t.4, and s.t.5). Waylines generated by such a plan and such equations are shown in FIG. 17B, in which the red line is the one side of the field boundary, see the image shown in FIG. 17A, and is the initial reference wayline and the blue lines are the generated waylines that were generated based on parameters of the initial wayline.

In some embodiments, $C^1$-continuous and $C^2$-continuous paths, or only $C^2$-continuous paths, are used in the interpolation described herein. A path is $C^1$-continuous if its derivative exists and is continuous. Paths that are only C1-continuous have discontinuities in their curvature. For example, a path composed of Dubins or Reeds-Shepp path segments has discontinuities in curvature at the points where the segments join. These discontinuities in C1-countiuous path result in changes in direction that may not be smooth enough for driving with passengers. Thus, a $C^2$-continuous is added in such embodiments, if its second derivative exists and is continuous. C2-continuous paths have continuous curvature and are smooth enough for driving with passengers.

FIG. 18 illustrates an example graphical output having a slider bar for adjusting the parameters of the waylines according to tradeoffs and the output can be a part of a graphical user interface (GUI)-such as a GUI provided by the computing system 200. The generation of waylines for a set of waylines can be alternatively based on a preference of an operator and the alternative generation of the waylines is selectable by the operator from a user interface (UI), such as a GUI. In some embodiments, the UI includes a slider for adjusting the parameters of the waylines according to one or more tradeoffs. For example, a slider is provided in the UI and is movable by a user to control the weights of an objective function (e.g., to adjust w1,w2, and w3 of the objection function described herein). If the operator cares less about one parameter of the set of waylines than another parameter, a lower value can be applied to corresponding one or more weights of the objective function via the slider (e.g., if the operator cares less about skipped area size than wayline length, then a lower value can be given to w3; which coincides with minimization of skipped area being a lower priority than wayline length in the objective functions). In some embodiments, the UI allows for multiple different selection choices for adjusting the objective function to adjust for different tradeoffs (e.g., adjust for less overlap or skipped area, or straightness of waylines versus skipped area, or less overlap versus straightness of waylines, etc.).

Some portions of the preceding detailed descriptions have been presented in terms of algorithms and symbolic representations of operations on data bits within a computer memory. These algorithmic descriptions and representations are the ways used by those skilled in the data processing arts to most effectively convey the substance of their work to others skilled in the art. An algorithm is here, and generally, conceived to be a self-consistent sequence of operations leading to a predetermined result. The operations are those requiring physical manipulations of physical quantities. Usually, though not necessarily, these quantities take the form of electrical or magnetic signals capable of being stored, combined, compared, and otherwise manipulated. It has proven convenient at times, principally for reasons of common usage, to refer to these signals as bits, values, elements, symbols, characters, terms, numbers, or the like. It should be borne in mind, however, that these and similar terms are to be associated with the appropriate physical quantities and are merely convenient labels applied to these quantities. The present disclosure can refer to the action and processes of a computing system, or similar electronic computing device, which manipulates and transforms data represented as physical (electronic) quantities within the computing system's registers and memories into other data similarly represented as physical quantities within the computing system memories or registers or other such information storage systems.

While the invention has been described in conjunction with the specific embodiments described herein, it is evident that many alternatives, combinations, modifications and variations are apparent to those skilled in the art. Accordingly, the example embodiments of the invention, as set forth herein are intended to be illustrative only, and not in a limiting sense. Various changes can be made without departing from the spirit and scope of the invention.

**Claims**

1. A method, comprising:

   receiving, by a computing system (102, 200), mobile machine location information (104), the mobile machine location information comprising a series of time-stamped locations of a mobile machine (110) as it moves through an area of land during a time period (step 302), and the mobile machine comprising an implement used for farming, construction, or forestry;
   receiving, by the computing system (102, 200), satellite images (106) of the area of land (step 304);
   using, by the computing system (102, 200), a machine learning model (109b) to determine and generate a model-based bounding box (112, 1202a) for the area of land (step 308).

2. The method according to claim 1, further comprising training, by the computing system (102, 200), the model using the mobile machine location information (104) and the satellite images (106) (step 306).

3. The method according to claim 1 or 2, further comprising:

   receiving, by the computing system (102, 200), secondary information (114) associated with the mobile machine location information (104), wherein the received secondary information is from within the time period (step 402); and
   further using, by the computing system (102, 200), the machine learning model (108) using the received secondary information (114) (step 404) to determine and generate the model-based bounding box (112, 1202a) for the area of land (step 308).

4. The method according to any one of the preceding claims, wherein the received secondary information (114) comprises implement usage information from within the time period.

5. The method according to any one of the preceding claims, wherein the received secondary information (114) comprises: implement size information of the implement; and/or machine size information of the mobile machine (110).

6. The method according to any one of the preceding claims, further comprising:

    receiving, by the computing system (102, 200), a selection of a mapped area of land from a user interface (116, 1100), the mapped area of land comprising the area of land bounded by a user-selected bounding box (1102) (step 502); and
    determining and generating, by the computing system (102, 200), waylines (1204a) within the model-based bounding box (1202a) according to attributes of the model-based bounding box (step 504).

7. The method according to claim 6, wherein the determination of the waylines (1204a) is further according to secondary wayline generation factors (e.g., see FIGS. 14A to 18).

8. The method according to claim 6 or 7, determining and generating, by the computing system (102, 200), wayline headlands (1206a) within the model-based bounding box (1202a) according to attributes of the model-based bounding box (step 602).

9. The method according to any one of claims 6 to 8, wherein the determination of the wayline headlands (1206a) is further according to secondary wayline generation factors or secondary headland generation factors.

10. The method according to any one of claims 6 to 9, further comprising:

    generating, by the computing system (102, 200), a graphical representation of the model-based bounding box (1202a) (step 702), wherein the graphical representation of the model-based bounding box is within a graphical representation of the mapped area of land; and
    displaying, via the user interface, the graphical representation of the model-based bounding box (1202a) within the graphical representation of the mapped area of land (step 704).

11. The method according to claim 10, further comprising:

    generating, by the computing system (102, 200), a graphical representation of the waylines (1204a) (step 706), wherein the graphical representation of the waylines is within the graphical representation of the model-based bounding box (1202a); and
    further displaying, via the user interface, the graphical representations of the waylines (1204a) within the graphical representation of the model-based bounding box (1202a) (step 708).

12. The method according to claim 11, further comprising:

    generating, by the computing system (102, 200), a graphical representation of the wayline headlands (1206a) (step 710), wherein the graphical representation of the wayline headlands is within the graphical representation of the model-based bounding box (1202a); and
    further displaying, via the user interface, the graphical representations of the wayline headlands (1206a) within the graphical representation of the model-based bounding box (1202a) (step 712).

13. The method according to any one of claims 6 to 12, further comprising:

    receiving, by the computing system, a selection of a range of time (1000) for operating the mobile machine (110) within the area of land bounded by the user-selected bounding box (1102) (step 802); and
    determining and generating, by the computing system (102, 200), a schedule (1300) for operating the machine along the waylines (1204a) according to the model-based bounding box (1202a), the waylines, the headlands (1206a), or a combination thereof and the selection of the range of time (step 804).

**14.** The method according to claim 13, further comprising:

generating, by the computing system (102, 200), a graphical representation of the schedule (1300) (step 806); and
displaying, via the user interface, the graphical representation of the schedule (1300) (step 808).

**15.** The method according to any one of the preceding claims, further comprising using, by the computing system (102, 200), the machine learning model (109b) to determine and generate waylines and wayline headlands within the model-based bounding box (112, 1202a) for the area of land (step 308).

**FIG. 1**

100

COMPUTING SYSTEM 102

MACHINE LOCATION INFORMATION 104 — INPUT 1

BIRD'S-EYE VIEW INFORMATION 106 — INPUT 2

SECONDARY INFORMATION 114 — INPUT 3

MODEL 108

TRAINING 109a

TRAINED MODEL 109b

OUTPUT

ROUTE INFORMATION (INCLUDING BOUNDING BOX INFORMATION, WAYLINES, AND WAYLINE HEADLANDS) 112

USER INTERFACE 116

MOBILE MACHINE 110

COMPUTING
SYSTEM
200

218

MEMORY
204

INSTRUCTIONS
214

PROCESSING DEVICE
202

INSTRUCTIONS
214

STATIC MEMORY
206

NETWORK INTERFACE
DEVICE
208

DATA STORAGE SYSTEM
210

MACHINE-READABLE
MEDIUM
212

INSTRUCTIONS
214

USER INTERFACE
(E.G., UI 116)
216

# FIG. 2

300

GENERATING AND SENDING, BY A SENSOR SYSTEM, MOBILE MACHINE LOCATION
INFORMATION
301

RECEIVING, BY A COMPUTING SYSTEM, MOBILE MACHINE LOCATION INFORMATION,
THE MOBILE MACHINE LOCATION INFORMATION INCLUDING A SERIES OF
TIME-STAMPED LOCATION OF A MOBILE MACHINE AS IT MOVES THROUGH AN
AREA OF LAND DURING A TIME PERIOD
302

RECEIVING, BY THE COMPUTING SYSTEM, BIRD'S-EYE VIEW INFORMATION
INCLUDING A VIEW OF THE AREA OF LAND (E.G.., INCLUDING SATELLITE IMAGES
OF THE AREA OF LAND DURING THE PERIOD)
304

TRAINING, BY THE COMPUTING SYSTEM, A MODEL USING THE LOCATION
INFORMATION AND THE BIRD'S-EYE VIEW INFORMATION
306

USING, BY THE COMPUTING SYSTEM, THE TRAINED MODEL TO GENERATE
ROUTE INFORMATION (INCLUDING BOUNDING BOXES, WAYLINES, AND
WAYLINE HEADLANDS)
308

# FIG. 3

400

RECEIVING, BY THE COMPUTING SYSTEM, SECONDARY
INFORMATION ASSOCIATED WITH THE MOBILE MACHINE
LOCATION INFORMATION
402

304

306

302

...

FURTHER TRAINING, BY THE COMPUTING
SYSTEM, THE MACHINE LEARNING MODEL
USING THE SECONDARY INFORMATION
404

308

# FIG. 4

500

| 300 | 400 |
|---|---|

RECEIVING, BY THE COMPUTING SYSTEM, A SELECTION OF A MAPPED AREA OF LAND FROM A USER INTERFACE THE MAPPED AREA OF LAND COMPRISING THE AREA OF LAND BOUNDING BY A BOUNDING BOX
502

DETERMINING AND GENERATING, BY THE COMPUTING SYSTEM, WAYLINES WITHIN THE BOUNDING BOX ACCORDING TO ATTRIBUTES OF THE BOUNDING BOX
504

# FIG. 5

600

| 300 | 400 |
|---|---|

502

504

DETERMINING AND GENERATING, BY THE COMPUTING SYSTEM, WAYLINE HEADLANDS WITHIN THE DETERMINED BOUNDING BOX ACCORDING TO ATTRIBUTES OF THE DETERMINED BOUNDING BOX
602

# FIG. 6

| 300 | 400 | | 500 | | 600 |

GENERATING, BY THE COMPUTING SYSTEM, A GRAPHICAL REPRESENTATION OF THE BOUNDING BOX
702

GENERATING, BY THE SYSTEM, A GRAPHICAL REPRESENTATION OF THE WAYLINES
706

GENERATING, BY THE SYSTEM, A GRAPHICAL REPRESENTATION OF THE WAYLINE HEADLANDS
710

DISPLAYING, VIA THE USER INTERFACE THE GRAPHICAL REPRESENTATION OF THE BOUNDING BOX WITHIN THE GRAPHICAL REPRESENTATION OF THE MAPPED AREA
704

DISPLAYING, VIA THE UI, THE GRAPHICAL REPRESENTATION OF THE WAYLINES WITHIN THE REPRESENTATION OF THE BOX
708

DISPLAYING, VIA THE UI, THE REPRESENTATION OF THE HEADLANDS WITHIN THE REPRESENTATION OF THE BOX
712

**FIG. 7**

EP 4 677 981 A1

800

| 300 | 400 | 500 | 600 | 700 |

RECEIVING, BY THE COMPUTING SYSTEM, A SELECTION OF A RANGE OF TIME FOR OPERATING THE MOBILE MACHINE WITHIN THE AREA AND LAND BOUNDED BY THE BOUNDING BOX
802

DETERMINING AND GENERATING, BY THE SYSTEM, A SCHEDULE FOR OPERATING THE MACHINE ALONG THE WAYLINES ACCORDING TO THE BOX, THE WAYLINES, AND/OR THE HEADLANDS AND THE SELECTION OF THE RANGE OF TIME
804

GENERATING, BY THE SYSTEM, A GRAPHICAL REPRESENTATION OF THE SCHEDULE
806

DISPLAYING, VIA THE UI, THE GRAPHICAL REPRESENTATION OF THE SCHEDULE
808

# FIG. 8

EP 4 677 981 A1

900

ENHANCING THE LOCATION INFORMATION, THE BIRD'S-EYE VIEW INFORMATION, THE SECONDARY INFORMATION, OR A COMBINATION THEREOF ACCORDING TO DIGITAL SIGNAL PROCESSING OR OTHER PRE-PROCESSING
902

USING THE LOCATION INFORMATION, THE BIRD'S-EYE VIEW INFORMATION, THE SECONDARY INFORMATION, A COMBINATION THEREOF, OR A DERIVATIVE THEREOF AS AN INPUT TO A COMPUTING SCHEME
904

DETERMINING, BY THE COMPUTING SCHEME 907, ROUTE INFORMATION (INCLUDING BOUNDING BOX INFORMATION, WAYLINES, AND WAYLINE HEADLANDS)
906

SCHEME
907

INPUT LAYER

HIDDEN LAYER(S)

OUTPUT LAYER

USING AN OUTPUT OF THE SCHEME OR A DERIVATIVE THEREOF TO DETERMINE THE ROUTE INFORMATION
908

**FIG. 9**

1000

1st June 2018 to ...

< >

June 2018

| Mon | Tue | Wed | Thu | Fri | Sat | Sun |
|-----|-----|-----|-----|-----|-----|-----|
| 28 | 29 | 30 | 31 | 1 | 2 | 3 |
| 4 | 5 | 6 | 7 | 8 | 9 | 10 |
| 11 | 12 | 13 | 14 | 15 | 16 | 17 |
| 18 | 19 | 20 | 21 | 22 | 23 | 24 |
| 25 | 26 | 27 | 28 | 29 | 30 | |

July 2018

| Mon | Tue | Wed | Thu | Fri | Sat | Sun |
|-----|-----|-----|-----|-----|-----|-----|
| | | | | | | 1 |
| 2 | 3 | 4 | 5 | 6 | 7 | 8 |
| 9 | 10 | 11 | 12 | 13 | 14 | 15 |
| 16 | 17 | 18 | 19 | 20 | 21 | 22 |
| 23 | 24 | 25 | 26 | 27 | 28 | 29 |
| 30 | 31 | 1 | 2 | 3 | 4 | 5 |

## FIG. 10

1104  1102  1100

## FIG. 11

1100

**FIG. 12A**

1100

**FIG. 12B**

May 16, 2025          5 AM: field sectors 455-AB-1-00035, 455-AB-1-00036, 455-AB-1-00037
- location: field    6 AM: field sectors 455-AB-1-00040, 455-AB-1-00039, 455-AB-1-00038
455-AB-1             7 AM: field sectors 455-AB-1-00041, 455-AB-1-00042, 455-AB-1-00043
- task: planting     8 AM: field sectors 455-AB-1-00035, 455-AB-1-00036, 455-AB-1-00037
corn seeds           9 AM: field sectors 455-AB-1-00040, 455-AB-1-00041, 455-AB-1-00042
- predicted temp.    10 AM: field sectors 455-AB-1-00044, 455-AB-1-00043
65 degrees           11 AM: ...
Fahrenheit           12 PM: ...
- predicted          1 PM: ...
humidity 55%         2 PM: ...
- sunrise 5:30 AM    3 PM: ...
- sunset 8:45 PM     4 PM: field sectors 455-AB-1-00045, 455-AB-1-00046
- rain: 25%          5 PM: field sectors 455-AB-1-00049, 455-AB-1-00048, 455-AB-1-00047
- wind: 15 mph

1302

**FIG. 13**

EP 4 677 981 A1

$P_i$
$P_{i+1}$

$P_{i-1}$
$P$

**FIG. 14A**

$P_{i+1}$

$P_i$

$P$

$P_{i-1}$

**FIG. 14B**

Curved line connecting two point

Straight line connecting two point

**FIG. 14C**

P_ref_3

P_ref_2

P_ref_4

P_ref_1

1052 Skipped Areas

P_ref_5

1054 Swaths

P_new_2

P_new_3

P_new_4

P_new_5

P_new_1

## FIG. 15

Tangent vector

p_new$_i$ allowed offset direction range

+0.1

$\vec{n} = \left( e_{x_i}^{ref}, e_{y_i}^{ref} \right)$ Normal vector

-0.1

p_ref$_i$

1602

1604

previous wayline   new wayline

## FIG. 16

## FIG. 17A

## FIG. 17B

**User preference**

shorter wayline ⬛▬▬▬▬▬◎▬▬▬▬▷ Less skipped area

## FIG. 18

Europäisches
Patentamt
European
Patent Office
Office européen
des brevets

## EUROPEAN SEARCH REPORT

**Application Number**

EP 25 18 3787

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 7 381402 B2 (KUBOTA KK) 15 November 2023 (2023-11-15) | 1-5,15 | INV. A01B69/00 |
| Y | * English machine translation of cited paragraphs; paragraphs [0032], [0042], [0044], [0045], [0052], [0053], [0056] - [0058]; figures 1, 2, 6, 7-9 * ----- | 6-14 | |
| X | US 2022/299635 A1 (SERGEEV ALEXANDER IGOREVICH [US]) 22 September 2022 (2022-09-22) | 1 | |
| Y | * paragraphs [0047], [0084], [0104], [0105], [0162]; figures 8, 9, 10A * ----- | 6-14 | |
| A | US 2023/413711 A1 (KREYKES TODD A [US] ET AL) 28 December 2023 (2023-12-28) * paragraphs [0050] - [0052], [0054], [0055]; figure 3 * ----- | 1-15 | |

|  |
|---|
| **TECHNICAL FIELDS SEARCHED (IPC)** |
| A01B |

The present search report has been drawn up for all claims

| Place of search | Date of completion of the search | Examiner |
|---|---|---|
| Munich | 10 November 2025 | Weißbach, Mark |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

......................................................................................

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 25 18 3787

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2025

| Patent document cited in search report | | Publication date | Patent family member(s) | | Publication date |
|---|---|---|---|---|---|
| JP 7381402 | B2 | 15-11-2023 | JP | 7381402 B2 | 15-11-2023 |
| | | | JP | 2021007386 A | 28-01-2021 |
| US 2022299635 | A1 | 22-09-2022 | AU | 2022238342 A1 | 31-08-2023 |
| | | | CA | 3210914 A1 | 22-09-2022 |
| | | | CN | 117121055 A | 24-11-2023 |
| | | | EP | 4309129 A1 | 24-01-2024 |
| | | | IL | 305080 A | 01-10-2023 |
| | | | JP | 2024511712 A | 15-03-2024 |
| | | | KR | 20230158477 A | 20-11-2023 |
| | | | US | 2022299635 A1 | 22-09-2022 |
| | | | US | 2025216548 A1 | 03-07-2025 |
| | | | WO | 2022197831 A1 | 22-09-2022 |
| US 2023413711 | A1 | 28-12-2023 | BR | 102023006753 A2 | 02-01-2024 |
| | | | DE | 102023113765 A1 | 28-12-2023 |
| | | | US | 2023413711 A1 | 28-12-2023 |
| | | | US | 2025159431 A1 | 15-05-2025 |

EPO FORM P0459

For more details about this annex : see Official Journal of the European Patent Office, No. 12/82